# EUROPEAN PATENT APPLICATION

(11) **EP 4 622 399 A1**
(43) Date of publication of application: **24.09.2025**
(21) Application number: 24165246.0
(22) Date of filing: 21.03.2024
(51) Int. Cl.: H05K 1/02, H05K 3/28, H05K 3/00

(54) **PRINTED CIRCUIT BOARD, ELECTRICAL CIRCUIT ASSEMBLY AND METHODS OF PRODUCING A PRINTED CIRCUIT BOARD AND AN ELECTRICAL CIRCUIT ASSEMBLY**

(71) Applicant: ZF CV Systems Global GmbH, 3006 Bern (CH)
(72) Inventor: CALKA, Marcin, 54-404 Wroclaw (PL); SKOWRONSKI, Jakub, 52-234 Wroclaw (PL); KUBIEC, Tomasz, 55-080 Smolec (PL)
(74) Representative: Copi, Joachim

(57) **Abstract**

The invention is directed to a printed circuit board (100) comprising an insulating bulk layer (102) having a proximal surface (102a) and a distal surface (102b) that is opposite to the proximal surface (102a) one or more electrical connection elements (104) accessible from the proximal surface (102a) of the insulating bulk layer (102), the electrical connection elements (104) configured to connect electrical components (202) to be arranged on the proximal surface (102a) of the insulating bulk layer (102), wherein the distal surface (102b) is at least partially covered by a distal conductive layer (106) that is electrically isolated from the electrical connection elements (104).

## Description

The present invention relates to a printed circuit board, to an electrical circuit assembly comprising a printed circuit board, and to a respective methods of producing said printed circuit board and said electrical circuit assembly.

A printed circuit board (PCB), also called printed wiring board (PWB), is a medium used to connect or "wire" components to one another in a circuit.

It takes the form of a laminated sandwich structure of electrically conductive and electrically insulating layers: each of the electrically conductive layers is designed with an artwork pattern of traces, planes and other features (similar to wires on a flat surface) etched from one or more sheet layers of metal, e.g. copper, laminated onto and/or between sheet layers of an electrically non-conductive substrate.

The electric non-conductive or isolating substrate is typically a composite material from pre-impregnated fibers and partially cured polymer matrix, commonly referred to as prepreg. Electrical components, such as encapsulated electronic circuits or stand-alone electrical components such as resistors, capacitors, inductors, diodes, transistors, etc., may be fixed to conductive pads on the outer layers in the shape designed to accept the component's terminals, generally by means of soldering, to both electrically connect and mechanically fasten them to it.

Another manufacturing process adds electrical connection elements such as vias or micro-vias, which are plated-through holes that allow interconnections between the conductive layers, creating electrical paths between the terminals of the electrical components. Chemical etching divides the conductive layer into separate conducting lines called tracks or circuit traces, pads for connections, vias to pass connections between layers of conductive material and features such as solid conductive areas for electromagnetic shielding or other purposes. The tracks function as wires fixed in place, and are insulated from each other by air and the insulating substrate material.

The surface of a PCB may have a coating that protects the copper from corrosion and reduces the chances of solder shorts between traces or undesired electrical contact with stray bare wires. For its function in helping to prevent solder shorts, the coating is called solder resist or solder mask.

Known printed circuit boards can be single-sided (one outer electrically conductive layer, typically copper), double-sided (two outer electrically conductive layers on both sides of one substrate layer), or multi-layer (outer and inner electrically conductive layers, alternating with electrically insulating layers of substrate). Multi-layer PCBs allow for much higher component density, because circuit traces on the inner electrically conductive layers would otherwise take up surface space between components. The rise in popularity of multilayer PCBs with more than two, and especially with more than four, copper planes was concurrent with the adoption of surface mount technology.

A multi-layer printed circuit board has multiple layers of electrically conductive material, such as copper, which almost always are arranged in pairs. The number of layers and the interconnection designed between them (vias, plating through holes, -PTHs-) provide a general estimate of the board complexity. Using more layers allow for more routing options and better control of signal integrity, but are also time consuming and costly to manufacture. Likewise, selection of the vias for the board also allow fine tuning of the board size, escaping of signals off complex ICs, routing, and long term reliability, but are tightly coupled with production complexity and cost.

In multi-layer boards, the layers of material are laminated together in an alternating sandwich including conductive layers (e.g. copper) and insulating layers (e.g., substrate); each plane of conductive layer is etched, and any internal vias (that will not extend to both outer surfaces of the finished multilayer board) are plated-through, before the layers are laminated together. Only the outer layers need be coated with the solder resist; the inner conductive layers are protected by the adjacent substrate layers.

The thermal resistance of electronic components defines the maximum power dissipation of the components. The thermal resistance can be reduced by a proper PCB layout; however, heat transfer outside the PCB is critical to the final value of the thermal resistance of the components. There is therefore a need to develop effective heat transfer solutions for transferring heat outside the PCB.

In WO 00/74449 a printed circuit board is attached to a main board, which is based on a printed circuit board consisting of printed-conductor layers and insulating layers. The printed circuit board has no insulating layer on the bottom side. But if the main board is electrically conductive an electrically insulating layer is produced on the surface of the main board facing the printed circuit board, after which said printed circuit board is mounted on the main board.

The bottleneck is typically the interface between PCB and metal heatsink: the connection of the PCB to the heatsink should be as thin as possible to obtain a sufficiently low thermal resistance and thick enough for the selected material to guarantee the appropriate electrical resistance. However, both requirements are contradictory, which forces the PCB designer to compromise.

US 6.362, 964 B1 describes an adaptable planar module (APM), which includes a minimum insulated metal substrate (IMS substrate) suitable for power devices and other devices. The IMS substrate may support an input bridge, an inverter, and other components and sits beneath an open cavity of a printed circuit board. It provides for a thermally conductive substrate that is thermally connected to a heatsink so that the heat that is generated by a semiconductor device residing on the thermally conductive substrate may be withdrawn.

Other current solutions are based on a gap filler, gap pad or other types of thermal filler placed between the PCB and the heat sink; however, these solutions are rather cost-intensive and the application method is comparatively complex. Additionally, gap fillers tend to dry out and crack, which increases the thermal resistance. Also, their thickness negatively affects this parameter.

Thermal tapes are much thinner, but their high thermal resistivity reduces the benefits of their use. Besides, the application of thermal tapes is also comparatively complex and additional processes are needed, which significantly increases the final PCB production costs.

This is where the invention comes in, wherein it is an objective of the present invention to provide a solution to the above mentioned problems, or at least an alternative to the known solutions.

According to a first aspect of the present invention, a printed circuit board, also referred to herewithin as PCB, is disclosed. The PCB comprises an insulating bulk layer having a proximal surface and a distal surface that is opposite to the proximal surface. The proximal surface and the distal surface run substantially parallel to each other and are separated by a distance corresponding to the thickness of the insulating bulk layer, which extends in a direction perpendicular to the proximal surface and the distal surface. The PCB also comprises one or more electrical connection elements that are accessible from the proximal surface of the insulating bulk layer. The electrical connection elements are configured to connect electrical components to be arranged on the proximal surface of the insulating bulk layer. According to the invention, the distal surface is at least partially covered by a distal conductive layer that is electrically isolated from the electrical connection elements.

Therefore, instead of using an additional electrical insulation that is applied between the PCB and the heat sink, the insulation is provided by the insulating bulk layer. An outer conductive layer arranged distally, that is, opposite to the proximal conductive layer, is isolated by the insulating bulk layer, typically the prepreg from the closest conductive layer. There are, therefore, no vias or electrical connections available between an electrical component to be arranged on the proximal surface and the distal conductive layer. Further, the outer distal conductive layer does not need to be coated with a solder mask and can be made from a full conductive material, such as copper. Advantageously, the distal conductive layer, which can be the outer distal conductive layer of a double-sided or multi-layer PCB, is characterized by a planar and very good surface smoothness, such that the inventive PCB, with the internally electrically insulated distal conductive layer can be directly connected to a heat sink, which is also typically smooth and planar. The two planar smooth surfaces of the PCB and the heat sink form a well-thermally conductive structure and the thermal dissipation properties of the heat sink are well suited, therefore improving the heat transfer outside the PCB.

Upon use of the PCB in an electrical assembly, as it will be explained below, the heat generated in the electrical components, which are attached to the proximal surface of the PCB, is transferred to the PCB by the solder joints and then transferred to electrical connection elements. The heat is transferred through the insulating bulk layer to the distal conductive layer for heat dissipation, while the insulting bulk layer provides the necessary electrical insulation between the electrical connection elements (and thus the electrical components) and the distal conductive layer.

Further advantageous developments of the invention are found in the dependent claims and indicate in detail advantageous possibilities to realize the concept described above within the scope of the object as well as with regard to further advantages.

In the following, developments of the PCB of the first aspect of the invention will be disclosed.

In a development, the proximal surface of the insulating bulk layer is at least partially covered, or alternatively, fully covered, by a top external conductive layer. Thus, in this development, the PCB is a double-sided or, preferably, a multi-layer PCB allowing for a higher component density.

In a development, wherein the PCB is implemented as a multi-layer PCB, the one or more electrical connection elements comprise one or more internal conductive layers embedded in the insulating bulk layers in a direction substantially parallel to the proximal surface and the distal surface of the insulating bulk layer, and connecting vias for connecting one or more internal conductive layers to the proximal surface, in particular to the top external conductive layer. This implementation as a multi-layer PCB enables a much higher density of electrical components, since the electrical connections between them can be distributed among the different internal conductive layers.

In yet another development the distal conductive layer is arranged and configured to be in contact with a heat dissipation element, in particular a metal heat dissipation element, or metal heat sink, which, in a particular development, is an integral part of a housing element.

In yet another development, the printed circuit board further comprises one or more connecting holes traversing the insulating bulk layer from the proximal surface to the distal surface, for connecting the printed circuit board to a heat dissipation element. In particular, the heat dissipation element to be used in combination with the PCB comprises one or more connection recesses aligned with the connecting holes for receiving connecting elements.

In a further development the one or more connecting holes comprise a threaded inner surface for receiving threaded connecting elements, such as threaded screws, configured to cooperate with the threaded inner surface of the connecting holes.

A second aspect of the present invention is formed by an electrical circuit assembly. The electrical circuit assembly of the second aspect of the invention comprises a printed circuit board in accordance with the first aspect of the invention and thus shares its advantages, as discussed above.

The electrical circuit assembly comprises electrical components mechanically arranged on the proximal surface of the insulating bulk layer and electrically connected to the one or more electrical connection elements. The electrical components may include resistors, capacitors, inductors, diodes, transistors, integrated circuits, or any other type of electrical components compatible with a PCB. The electrical contacts of the electrical components are in contact with the electrical connection elements of the PBC, for instance, via soldering. The electrical circuit assembly also comprises a heat dissipation element, in particular a metal heat dissipation element, arranged in contact with the distal conductive layer of the printed circuit board.

Preferably, in a development the printed circuit board comprises one or more connecting holes traversing the insulating bulk layer from the proximal surface to the distal surface, for connecting the printed circuit board to the heat dissipation element. Accordingly, the heat dissipation element comprises one or more connection recesses aligned with the connecting holes in a connected state, i.e., when the printed circuit board is connected to the heat dissipation element. For connecting, in particular releasably connecting, both the PCB and the heat dissipation element, the electrical circuit assembly further comprises connecting elements, in particular threaded connecting elements, configured to mechanically fasten the printed circuit board to the heat dissipation element.

Alternatively, or additionally, in another development, the electrical circuit assembly comprises another type of mechanical connection element for mechanically fastening the PCB and the heat dissipation element such as edge seams, rivets or pins.

In another development, the electrical circuit assembly further comprises a housing element, wherein the heat dissipation element is an integral part of the housing element.

According to a third aspect of the invention, a method of producing a printed circuit board according to the first aspect of the invention is disclosed. The method comprises:
- receiving or providing a printed circuit board, comprising a proximal solder mask layer as an outermost proximal layer, a proximal conductive layer arranged under the proximal solder mask, an insulating bulk layer arranged under the proximal conductive layer and comprising at least one embedded electrical connection elements, a distal conductive layer arranged under the insulating bulk layer and a distal solder mask layer as an outermost distal layer;
- electrically connecting the proximal conductive layer to the at least one embedded electrical connection elements, while maintaining an electrical isolation between the proximal conductive layer and the distal conductive layer; and
- removing the distal solder mask layer.

A fourth aspect of the present invention is formed by a method for producing an electrical circuit assembly. The method comprises
- providing or producing a printed circuit board in accordance with the method of the third aspect,
- removing at least part of the proximal solder mask layer;
- electrically connecting electrical components to the proximal conductive layer; and
- mechanically connecting a heat dissipation element to the distal conductive layer.

These and other aspects of the invention will be apparent from and elucidated with reference to the embodiments described hereinafter.

The embodiments of the invention are described in the following on the basis of the drawing in comparison with the state of the art, which is also partly illustrated. The latter is not necessarily intended to represent the embodiments to scale. The drawing is, where useful for explanation, shown in schematized and/or slightly distorted form. With regard to additions to the teaching immediately recognizable from the drawing, reference is made to the relevant prior art. It should be kept in mind that numerous modifications and changes can be made to the form and detail of an embodiment without deviating from the general concept of the invention. The features of the invention disclosed in the description, in the drawing and in the claims may be essential for a further development of the invention, either individually or in any combination. In addition, all combinations of at least two of the features disclosed in the description, drawing and/or claims fall within the scope of the invention.

The general concept of the invention is not limited to the exact form or detail of the preferred embodiments shown and described below or to a subject matter, which would be limited in comparison to the subject matter as claimed in the claims.

For specified design ranges, values within specified limits of the ranges are also disclosed as limit values and thus are arbitrarily applicable and claimable.

The following drawing shows in:
- FIG. 1: a schematic diagram of an exemplary embodiment of a printed circuit board in accordance with a first embodiment of the invention;
- FIG. 2: a schematic diagram of a first embodiment of an exemplary electrical circuit assembly in accordance with the invention;
- FIG. 3: a schematic diagram of a second embodiment of an exemplary electrical circuit assembly in accordance with the invention; and
- FIG. 4: a flow diagram of an exemplary embodiment of a method for producing an electrical circuit assembly that comprises a method for producing a printed circuit board according to the invention.

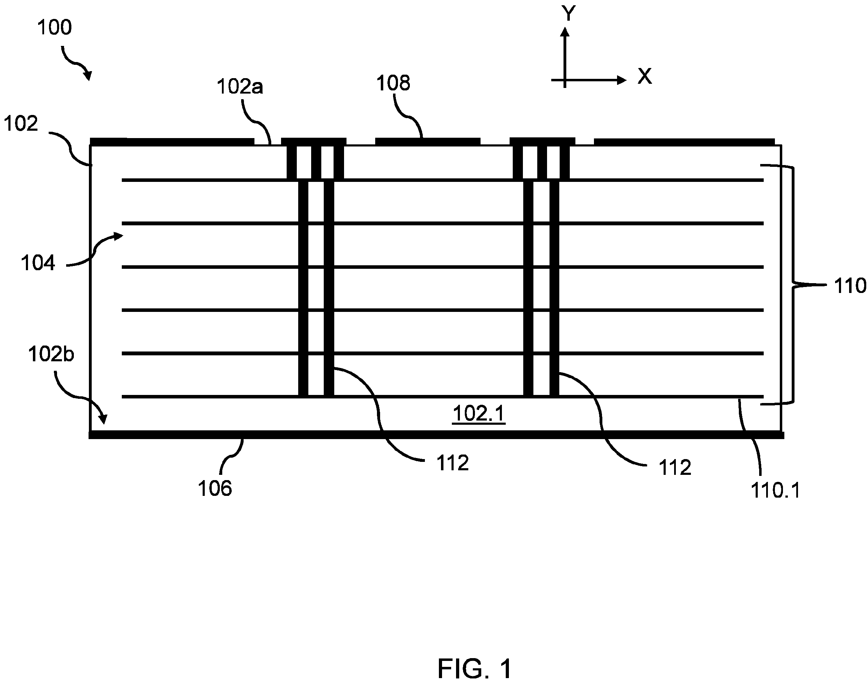

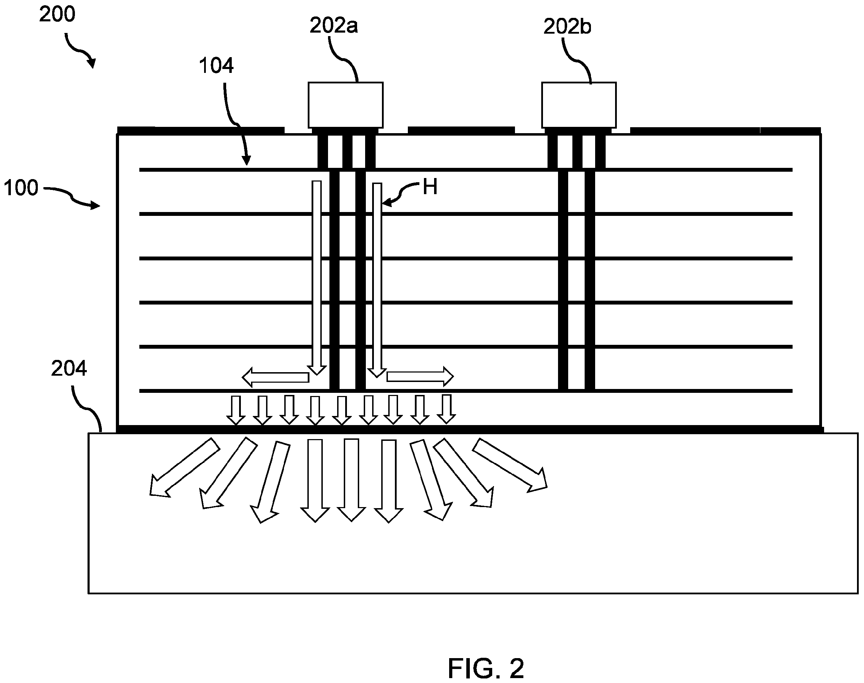

FIG. 1 shows a schematic diagram of an exemplary embodiment of a printed circuit board 100, also referred to as PCB, in accordance with a first embodiment of the invention. The printed circuit board 100 comprises an insulating bulk layer 102 having a proximal surface 102a and a distal surface 102b that is opposite to the proximal surface 102a. The insulating bulk layer 102 is, for example, a composite material from pre-impregnated fibers and partially cured polymer matrix, commonly referred to as prepreg. The PCB 100 of FIG. 1 is exemplarily a multi-layered PCB 100 having a proximal conductive layer 108 arranged on the proximal surface 102a of the insulating bulk layer 102, a distal conductive layer 106 arranged on the distal surface 102b and a plurality of internal electrical connection elements 104 accessible from the proximal surface 102a of the insulating bulk layer 102. The electrical connection elements 104 are configured to connect electrical components (202, see e.g., Fig. 2) that are to be arranged on the proximal surface 102a of the insulating bulk layer 102. In FIG. 1, the electrical connection elements comprise six internal conductive layers 110 embedded in the insulating bulk layer 102 in a direction X substantially parallel to the proximal surface 102a and the distal surface 102b of the insulating bulk layer 102 and connecting vias 112 for connecting one or more internal conductive layers 110 to the proximal surface 102a, in particular to the top external conductive layer 108. The connecting vias or plating through holes -PTH- extend in a direction Y substantially perpendicular to the direction X and thus perpendicular to the internal conductive layers 110.

In the printed circuit board 100 of Fig. 1, the distal surface 102b of the insulating bulk layer 102 is totally covered by a distal conductive layer 106 that is electrically isolated from the electrical connection elements 104. Typically, in known PCB designs, the distal conductive layer 106 is used as part of the electrical connection elements 104, and must therefore be isolated from other external metallic parts, for instance by means of gap fillers, gap pads or other types of electrically insulating thermal fillers.

According to the proposed solution, the distal conductive layer 106 is not electrically connected to the electrical connection elements and the necessary electrical insulation is provided by the existing insulating bulk layer 102, namely by that part of the insulating bulk layer 102.1 arranged between the most distal internal conductive layer 110.1 and the distal conductive layer 106. Further, the prepreg material has better thermal properties than the typically used solder resists or self-adhesive foils. As an example, the thermal conductivity of prepreg material is in the order of 0.7 W*m⁻¹*K⁻¹, whereas the thermal conductivity of the solder resist is in the order of 0.3 W*m⁻¹*K⁻¹ and that of the self-adhesive foil in the order of 0.15 W*m⁻¹*K⁻¹. The distal conductive layer 106 is preferably arranged in a planar and smooth state and thus configured to be in contact with an external heat dissipation element that preferably has a contact surface that is also planar and smooth.

FIG. 2 shows a schematic diagram of a first embodiment of an exemplary electrical circuit assembly 200 in accordance with the invention. The electrical circuit assembly 200, comprises a printed circuit board 100, such as, for example, the PCB described with reference to FIG. 1 above. The electrical circuit assembly also comprises electrical components 202a, 202b mechanically arranged on the proximal surface 102a of the insulating bulk layer 102, or on the proximal conductive layer 108, and electrically connected to the electrical connection elements 104. Further, the electrical circuit assembly 200, comprises a heat dissipation element 204, such as a metallic heat sink, arranged in mechanical contact with the distal conductive layer 106 of the printed circuit board 100. The heat dissipation route of heat H generated by the electrical component 202a is indicated with the white arrows. The heat H propagates primarily via the electrical connection elements 104, namely the vias 112 and the internal conductive layers 110 (see FIG. 1) and then transverses the most distal part 102.1 of the insulating bulk layer to the distal conductive layer 106 that is in contact with the heat sink 204.

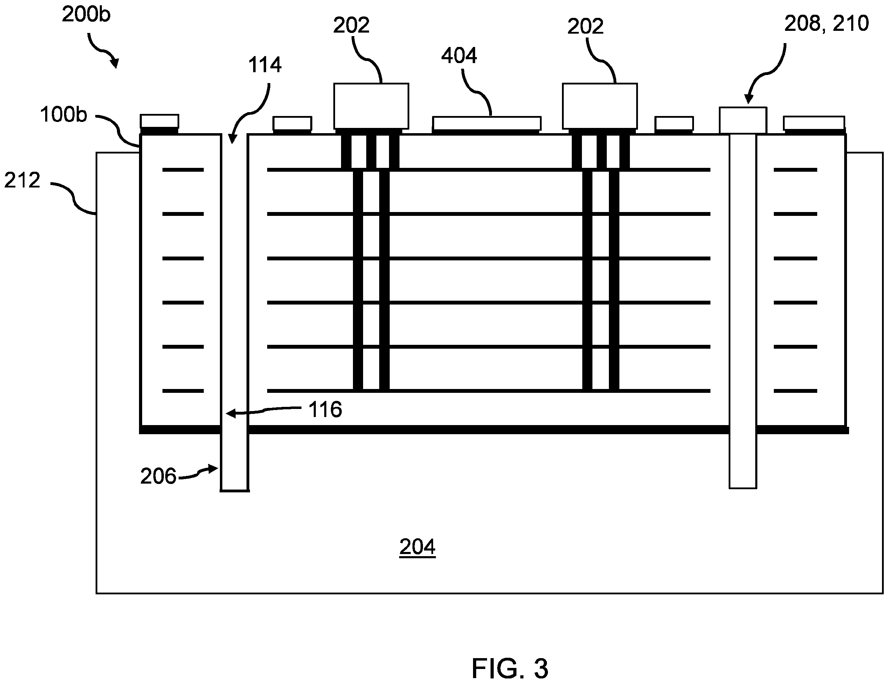

FIG. 3 shows a schematic diagram of a second embodiment of an exemplary electrical circuit assembly 200b in accordance with the invention. The following discussion will be focused on the differences between the electrical circuit assembly 200 of FIG. 2 and the electrical circuit assembly 200b of FIG. 3. Those technical features having the same, or a similar, technical function, will be referred to using the same reference numbers for the sake of clarity. The electrical circuit assembly comprises a PCB 100b that, in comparison to the PCB 100 of FIG. 1 or FIG. 2, further includes connecting holes 114 traversing the insulating bulk layer 102 from the proximal surface 102a to the distal surface 102b, for connecting the printed circuit board 100 to an external heat dissipation element 204 of the electrical circuit assemble 200b. In particular, the connecting holes 114 comprise a threaded inner surface 116 for receiving threaded connecting elements 208 configured to cooperate with the threaded inner surface 116.

The heat dissipation element 204 comprises respective connection recesses 206 that, in a connected state, are aligned with the connecting holes 114 of the PCB 100b. The electrical circuit assembly 200b further comprises connecting elements 208, in particular threaded connecting elements 210, that are configured to mechanically fasten the printed circuit board 100b to the heat dissipation element 204. In the particular example shown in FIG. 3, the electrical circuit assembly 200b further comprises a housing element 212, wherein the heat dissipation element 204 is an integral part of the housing element 212.

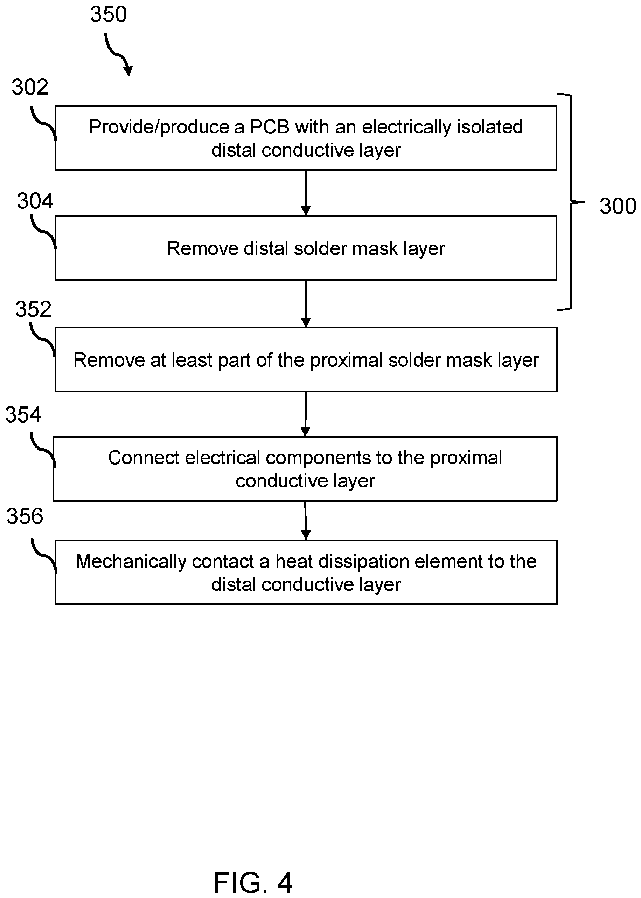

FIG. 4 shows a flow diagram of an exemplary embodiment of a method 350 for producing an electrical circuit assembly 200, the method 350 first comprises a method 300 for producing a printed circuit board 100 according to the invention. The method 300 comprises, in a step 302, providing or producing a printed circuit board comprising a proximal solder mask layer 404 (see FIG. 3) as an outermost proximal layer, a proximal conductive layer 108 (see. FIG. 1) arranged directly in contact with proximal solder mask layer 404, an insulating bulk layer 102 arranged directly in contact with the proximal conductive layer 108 and comprising at least one embedded electrical connection element 104, a distal conductive layer 106 arranged directly in contact with the insulating bulk layer 102 and a distal solder mask layer (not shown, but analogous to the proximal solder mask layer 404) as an outermost distal layer directly in contact with the insulating bulk layer 102. The proximal conductive layer 108 is electrically connected to the at least one embedded electrical connection element 104, while maintaining an electrical isolation between the proximal conductive layer 108 and the distal conductive layer 106. The method 300 further comprises removing, in a step 304, the distal solder mask layer, such that the electrically isolated distal conductive layer can be brought directly in contact with a heat dissipation element.

The method 350 further comprises removing, in a step 352, at least part of the proximal solder mask layer 404, electrically connecting, in a step 354, electrical components 202 to the proximal conductive layer 108 and, mechanically connecting, in a step 356, a heat dissipation element 204 directly to the distal conductive layer 106.

In summary, the invention is directed to a printed circuit board comprising an insulating bulk layer having a proximal surface and a distal surface that is opposite to the proximal surface one or more electrical connection elements accessible from the proximal surface of the insulating bulk layer, the electrical connection elements configured to connect electrical components to be arranged on the proximal surface of the insulating bulk layer, wherein the distal surface is at least partially covered by a distal conductive layer that is electrically isolated from the electrical connection elements.

Other variations to the disclosed embodiments can be understood and effected by those skilled in the art in practicing the claimed invention, from a study of the drawings, the disclosure, and the appended claims.

In the claims, the word "comprising" does not exclude other elements or steps, and the indefinite article "a" or "an" does not exclude a plurality.

A single unit or device may fulfill the functions of several items recited in the claims. The mere fact that certain measures are recited in mutually different dependent claims does not indicate that a combination of these measures cannot be used to advantage.

Any reference signs in the claims should not be construed as limiting the scope.

### REFERENCE LIST (PART OF THE DESCRIPTION)

- 100: Printed circuit board (PCB)
- 100b: Printed circuit board (PCB)
- 102: Insulating bulk layer
- 102.1: Most distal portion of insulating bulk layer
- 102a: Proximal surface of insulating bulk layer
- 102b: Distal surface of insulating bulk layer
- 104: Electrical connection elements
- 106: Distal conductive layer
- 108: Proximal conductive layer
- 110: Internal conductive layers
- 110.1: Most distal internal conductive layer
- 112: Connecting vias
- 114: Connecting holes
- 116: Inner surface of connecting holes
- 200: Electrical circuit assembly
- 200b: Electrical circuit assembly
- 202: Electrical components
- 202a: Electrical component
- 202b: Electrical component
- 204: Heat dissipation element
- 206: Connecting recess
- 208: Connecting elements
- 210: Connecting elements (Threaded)
- 212: Housing element
- 300: Method
- 302: Method step
- 304: Method step
- 350: Method
- 352: Method step
- 354: Method step
- 356: Method step
- 404: Proximal solder mask layer
- 406: Distal solder mask layer
- H: Heat
- X: direction
- Y: direction

## Claims

1. Printed circuit board (100) comprising:
- an insulating bulk layer (102) having a proximal surface (102a) and a distal surface (102b) that is opposite to the proximal surface (102a);
- one or more electrical connection elements (104) accessible from the proximal surface (102a) of the insulating bulk layer (102), the electrical connection elements (104) configured to connect electrical components (202) to be arranged on the proximal surface (102a) of the insulating bulk layer (102);
**characterized in that**, the distal surface (102b) is at least partially covered by a distal conductive layer (106) that is electrically isolated from the electrical connection elements (104).

2. Printed circuit board according to claim 1, wherein the proximal surface (102) is at least partially covered by a top external conductive layer (108).

3. Printed circuit board (100) according to claim 1 or 2, wherein the one or more electrical connection elements (104) comprise one or more internal conductive layers (110) embedded in the insulating bulk layer (102) in a direction (X) substantially parallel to the proximal surface (102a) and the distal surface (102b) of the insulating bulk layer (102) and connecting vias (112) for connecting one or more internal conductive layers (110) to the proximal surface (102a), in particular to the top external conductive layer (108).

4. Printed circuit board (100) according to any of the preceding claims, wherein the distal conductive layer (106) is arranged and configured to be in contact with an external heat dissipation element (204).

5. Printed circuit board (100b) according to any of the preceding claims, further comprising one or more connecting holes (114) traversing the insulating bulk layer (102) from the proximal surface (102a) to the distal surface (102b), for connecting the printed circuit board (100) to an external heat dissipation element (204).

6. Printed circuit board (100) according to claim 5, wherein the one or more connecting holes (114) comprise a threaded inner surface (116) for receiving threaded connecting elements (208) configured to cooperate with the threaded inner surface (116).

7. Electrical circuit assembly (200), comprising;
- a printed circuit board (100) in accordance with any of the preceding claims
- electrical components (202) mechanically arranged on the proximal surface (102a) of the insulating bulk layer (102) and electrically connected to the one or more electrical connection elements (104); and
- a heat dissipation element (204) arranged in contact with the distal conductive layer (106) of the printed circuit board (100).

8. Electrical circuit assembly (200b) according to claim 7, wherein
- the printed circuit board (100b) comprises one or more connecting holes (114) traversing the insulating bulk layer (102) from the proximal surface (102a) to the distal surface (102b), for connecting the printed circuit board (100) to the heat dissipation element (204),
- the heat dissipation element (204) comprises one or more connection recesses (206) aligned with the connecting holes (114) in a connected state;
the electrical circuit assembly (200) further comprising connecting elements (208), in particular threaded connecting elements (210), configured to mechanically fasten the printed circuit board (100) to the heat dissipation element (204).

9. Electrical circuit assembly (200b) according to claim 7 or 8, further comprising a housing element (212), wherein the heat dissipation element (204) is an integral part of the housing element (212).

10. Method (300) for producing a printed circuit board (100) according to any of the claims 1 to 6, the method comprising:
- providing or producing (302) a printed circuit board (400) comprising a proximal solder mask layer (404) as an outermost proximal layer, a proximal conductive layer (108) arranged directly in contact with proximal solder mask layer (404), an insulating bulk layer (102) arranged directly in contact with the proximal conductive layer (108) and comprising at least one embedded electrical connection element (104), a distal conductive layer (106) arranged directly in contact with the insulating bulk layer (102) and a distal solder mask layer (406) as an outermost distal layer directly in contact with the insulating bulk layer (102), wherein the proximal conductive layer (108) is electrically connected to the at least one embedded electrical connection element (104), while maintaining an electrical isolation between the proximal conductive layer (108) and the distal conductive layer (106); and
- removing (304) the distal solder mask layer.

11. Method (350) for producing an electrical circuit assembly (200), the method comprising;
- providing or producing a printed circuit board (100) in accordance with the method (300) of claim 10,
- removing (352) at least part of the proximal solder mask layer (404)
- electrically connecting (354) electrical components (202) to the proximal conductive layer (108);
- mechanically connecting (356) a heat dissipation element (204) to the distal conductive layer (106).
